# EUROPEAN PATENT SPECIFICATION

(11) **EP 3 101 702 B1**
(45) Date of publication and mention of the grant of the patent: **18.03.2020**
(21) Application number: 14881111.0
(22) Date of filing: 25.09.2014
(51) Int. Cl.: H01L 41/047, F02M 51/06, H01L 41/053, H01L 41/083, H01L 41/09

(54) **LAMINATED PIEZOELECTRIC ELEMENT, AND INJECTION DEVICE AND FUEL INJECTION SYSTEM PROVIDED WITH SAME**
BESCHICHTETES PIEZOELEKTRISCHES ELEMENT SOWIE INJEKTIONSVORRICHTUNG UND BRENNSTOFFEINSPRITZSYSTEM DAMIT
ÉLÉMENT PIÉZOÉLECTRIQUE STRATIFIÉ, DISPOSITIF D'INJECTION ET SYSTÈME D'INJECTION DE COMBUSTIBLE COMPRENANT L'ÉLÉMENT PIÉZOÉLECTRIQUE

(30) Priority: 29.01.2014 JP 2014014427
(43) Date of publication of application: 07.12.2016
(73) Proprietor: Kyocera Corporation, Kyoto-shi Kyoto 612-8501 (JP)
(72) Inventor: ASAKURA, Yasuhiro, Kyoto-shi, Kyoto 612-8501 (JP)
(74) Representative: Viering, Jentschura & Partner mbB Patent- und Rechtsanwälte
(86) International application number: PCT/JP2014/075463
(87) International publication number: WO 2015/114879

(56) References cited:
- WO-A1-2012/057327
- WO-A1-2013/031727
- JP-A- 2006 303 044
- US-A1- 2006 232 172
- US-A1- 2008 001 503

## Description

### Technical Field

The present invention relates to a multi-layer piezoelectric element used as, for example, a piezoelectric drive element (piezoelectric actuator), a piezoelectric sensor element, a piezoelectric circuit element, and the like, and an injection device and fuel-injection system containing the multi-layer piezoelectric element.

### Background Art

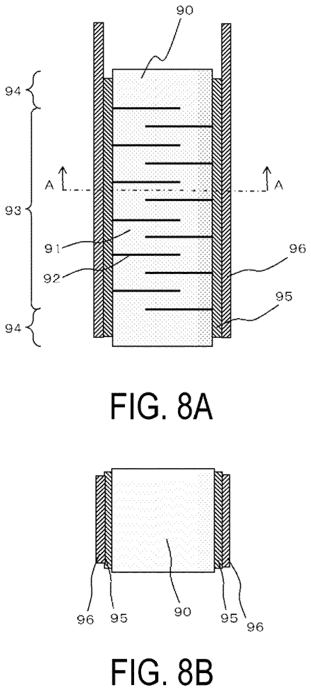

As illustrated in FIGS. 8A and 8B, multi-layer piezoelectric elements having a configuration including a stacked body 90 that has an active section 93 including piezoelectric layers 91 and internal electrode layers 92 laminated together, and an inactive section 94 located at both ends in a stacking direction of the active section 93: an electrically conductive bonding material 95 disposed on a side surface of the stacked body 90 from the active section 93 to the inactive section 94; and an external electrode plate 96 mounted on the side surface of the stacked body 90 with the electrically conductive bonding material 95 interposed therebetween are known (see Patent Literature 1).

### Citation List

### Patent Literature

Patent Literature 1: Japanese Unexamined Patent Application Publication No. 2005-223014A

US 2006/0232172 A1 discloses that a laminated-type piezoelectric element comprises a first external electrode layer located at a side area of the laminated-type piezoelectric element and being electrically continuous to internal electrode layers, and comprises plural expansible and contractible opening portions in a stacking direction of the laminated-type piezoelectric element (cf. abstract). This document further discloses that an insulating resin member is formed between the internal electrode layers and the first external electrode layers disposed in the laminated-type piezoelectric element (cf. paragraph [0063]).

US 2008/0001503 A1discloses that a multilayer piezoelectric element has a pair of outer electrodes and a multilayer ceramic body composed of piezoelectric layers and inner electrode layers which are alternately stacked, wherein the outer electrodes are formed on a pair of electrode connecting surfaces in the outer circumference surfaces of the multilayer ceramic body, and each outer electrode electrically connected to the inner electrode layers through connecting material is composed of a fixed part, a free part having plural expandable-openings, and a rigid part (cf. abstract). This document further discloses that the fixed part is divided into the two parts and that similarly, the free part is divided into the two parts (cf. paragraph [0111]).

### Summary of Invention

### Technical Problem

With the configuration of the multi-layer piezoelectric element described in Patent Literature 1, when driving, there is a possibility that cracking will occur within the electrically conductive bonding material 95, leading to the external electrode plate 96 detaching, electrical conduction being negatively affected, and driving coming to a halt.

Additionally, in an injection device and fuel-injection system containing such a multi-layer piezoelectric element, as a result of the electrical conduction of the electrically conductive jointing material in the multi-layer piezoelectric element being negatively affected, stable driving over an extended period of time may become impossible.

In light of the problems described above, an object of the invention is to provide a multi-layer piezoelectric element for which cracks in the electrically conductive bonding material are suppressed and durability is improved; and to provide an injection device and a fuel-injection system containing the multi-layer piezoelectric element.

### Solution to Problem

The present invention provides a multi-layer piezoelectric element according to claim 1, an injection device according to claim 6 and a fuel-injection system according to claim 7. Further embodiments of the present invention are described in the dependent claims.

### Advantageous Effects of Invention

According to the multi-layer piezoelectric element of the invention, stress applied to the electrically conductive bonding material when driving is reduced and cracking in the electrically conductive bonding material is suppressed. Therefore, a multi-layer piezoelectric element with improved durability can be provided.

Additionally, according to the injection device and fuel-injection system provided with the multi-layer piezoelectric element described above, stable driving over an extended period of time can be achieved as a result of providing the multi-layer piezoelectric element with improved durability.

### Brief Description of Drawings

FIG. 1A is a schematic vertical cross-sectional view illustrating an example of a multi-layer piezoelectric element. FIG. 1B is a drawing illustrating an example of a cross-section cut along line A-A depicted in FIG. 1A.
FIG. 2 is a drawing illustrating another example of a cross-section cut along line A-A depicted in FIG. 1A.
FIG. 3 is a drawing illustrating an example of a cross-section cut along line A-A depicted in FIG. 1A in accordance with the invention.
FIG. 4 is a drawing illustrating another example of a cross-section cut along line A-A depicted in FIG. 1A.
FIG. 5 is a drawing illustrating another example of a cross-section cut along line A-A depicted in FIG. 1A.
FIG. 6 is a schematic cross-sectional view illustrating an example of an embodiment of an injection device of the invention.
FIG. 7 is a schematic block diagram illustrating an example of an embodiment of a fuel-injection system of the invention.
FIG. 8A is a schematic vertical cross-sectional view illustrating an example of a conventional multi-layer piezoelectric element not according to the invention FIG. 8B is a drawing illustrating an example of a cross-section cut along line A-A depicted in FIG. 8A.

### Description of Embodiments

Hereinafter, a description of examples of an embodiment of a multi-layer piezoelectric element of the invention is given while referencing the drawings.

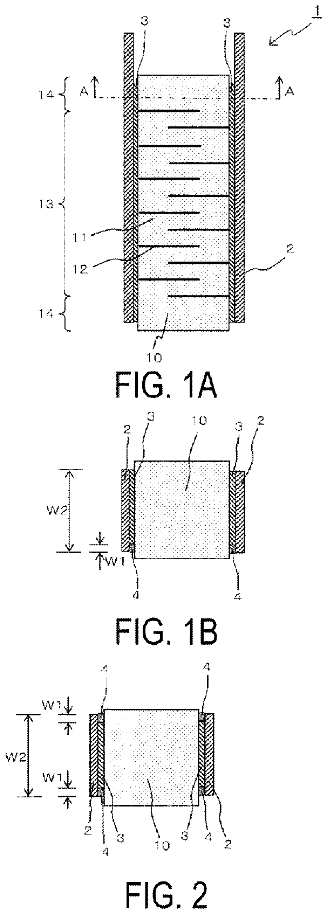

FIG. 1A is a schematic vertical cross-sectional view illustrating an example of a multi-layer piezoelectric element. . FIG. 1B is a drawing illustrating an example of a cross-section cut along line A-A depicted in FIG. 1A.

The multi-layer piezoelectric element 1 illustrated in FIGS. 1A and 1B includes a stacked body 10 in which piezoelectric layers 11 and internal electrode layers 12 are laminated, an external electrode plate 2 connected to a side surface of the stacked body 10 and electrically connected to the internal electrode layers 12, and an electrically conductive bonding material 3 disposed between the side surface of the stacked body 10 and one main surface of the external electrode plate 2. A resin layer 4 is disposed on at least one end of a space between the side surface of the stacked body 10 and the one main surface of the external electrode plate 2 in a width direction in a cross-sectional view perpendicular to the side surface of the stacked body 10.

The stacked body 10 constituting the multi-layer piezoelectric element 1 includes an active section 13 in which the piezoelectric layers 11 and the internal electrode layers 12 are laminated; and inactive sections 14, located outside the active section 13, made from the piezoelectric layers 11 disposed at both ends in a stacking direction of the stacked body 10. The stacked body 10 is formed into a rectangular parallelepiped shape having, for example, a length of 0.5 to 10 mm, a width of 0.5 to 10 mm, and a height of 1 to 100 mm.

The piezoelectric layers 11 constituting the stacked body 10 are formed from a ceramic having piezoelectric properties. Examples of such a ceramic that can be used include perovskite-type oxides made from lead zirconate titanate (PbZrO₃-PbTiO₃), lithium niobate (LiNbO₃), lithium tantalate (LiTaO₃), and the like. A thickness of each of the piezoelectric layers 11 is, for example, from 3 to 250 µm.

The internal electrode layers 12 constituting the stacked body 10 are formed by firing with the ceramics that forms the piezoelectric layers 11 at the same time. The internal electrode layers 12 are alternately laminated with the piezoelectric layers 11 so as to be over and under the piezoelectric layers 11, and apply driving voltage to the piezoelectric layers 11 sandwiched therebetween due to positive electrodes and negative electrodes being arranged in the lamination order. Examples of materials that can be used for forming the internal electrode layers 12 include electrical conductors having silver-palladium alloys, which have low reactivity with piezoelectric ceramics, as a primary component, or electrical conductors containing copper, platinum, or the like. In the example illustrated in FIGS. 1A and 1B, each of the positive electrodes and the negative electrodes lead out alternately to a pair of opposing side surfaces of the stacked body 10, and are electrically connected to a pair of electrically conductive bonding materials 3 disposed on the side surfaces of the stacked body 10. A thickness of each of the internal electrode layers 12 is, for example, from 0.1 to 5 µm.

Additionally, the external electrode plate 2 is connected to the side surface of the stacked body 10 with the electrically conductive bonding material 3 interposed therebetween, and the external electrode plate 2 is electrically connected to the internal electrode layers 12. Specifically, each of the pair of external electrode plates 2 is disposed on each of the pair of opposing side surfaces of the stacked body 10, is electrically connected to the internal electrode layers 12 via the electrically conductive bonding material 3, and a portion thereof extends past one edge of the stacked body 10 in the stacking direction. The pair of external electrode plates 2 is made from a flat metal plate of copper, iron, stainless steel, phosphor bronze, or the like and is formed, for example, having a width of 0.5 to 10 mm and a thickness of 0.1 to 0.3 mm. In addition to flat metal plates, in order to obtain a benefit of mitigating stress generated by the expansion and contraction of the stacked body 1, metal plates machined into, for example, a form having slits in the horizontal direction or a reticulated form may be used as the external electrode plates 2.

The electrically conductive bonding material 3 is disposed between each of the side surfaces of the stacked body 10 and the one main surface of each of the external electrode plates 2, from the active section 13 to the inactive sections 14; and is electrically connected to the external electrode plates 2 and the ends of the internal electrode layers 12 leading out to the side surfaces of the stacked body 10. The electrically conductive bonding material 3 is preferably made from an electrically conductive adhesive made from, for example, an epoxy resin or a polyimide resin containing metal powder with excellent electrical conductivity such as Ag powder, Cu powder, or the like. In a cross-sectional view of the electrically conductive bonding material 3 perpendicular to the side surfaces of the stacked body 10, the electrically conductive bonding material 3 is formed with a thickness of 5 to 70 µm.

Note that while not illustrated in the drawings, an electrical conductor layer electrically connected to the ends of the internal electrode layers 12 may be disposed on the side surfaces of the stacked body 10, and this electrical conductor layer may be connected to each of the external electrode plates 2 by disposing the electrically conductive bonding material 3 on a surface of the electrical conductor layer.

Moreover, as illustrated in FIG. 1B, the resin layer 4 is disposed on at least one end of the space between each of the side surfaces of the stacked body 10 and the one main surface of each of the external electrode plates 2 in the width direction in a cross-sectional view perpendicular to the side surface of the stacked body 10. Herein, the resin layer 4 is a layer formed from a resin free of electrical conductive particles. Preferable examples of the resin forming the resin layer 4 include epoxy, acrylic, and imide resins. Furthermore, in cases where the electrically conductive bonding material 3 is made from an electrical conductive adhesive containing a resin, a material that is different from the resin forming the electrically conductive adhesive may be selected as the resin forming the resin layer 4 so as to align the coefficients of thermal expansion of the electrically conductive bonding material 3 and the resin layer 4. As a result of such selection, the load applied to the electrically conductive bonding material 3 due to thermal stress can be reduced. Note that, "in a cross-sectional view of the electrically conductive bonding material 3 perpendicular to the side surfaces of the stacked body 10" means viewing the electrically conductive bonding material 3 from the stacking direction (the vertical direction in FIG. 1A). Additionally, the "one main surface of the external electrode plate 2" refers to the main surface on a side of the stacked body 10 facing the stacked body 10, and the main surface primarily bonded to the electrically conductive bonding material 3.

The resin layer 4 is a constituent that is disposed so as to extend in the stacking direction on at least one end of the space between each of the side surfaces of the stacked body 10 and the one main surface of each of the external electrode plates 2 in the width direction. In a cross-sectional view of the electrically conductive bonding material 3 perpendicular to the side surfaces of the stacked body 10, as illustrated in FIG. 1B, the stacked body 10 has a configuration in which the resin layer 4 is disposed on at least one end of the space between each of the side surfaces of the stacked body 10 and the one main surface of each of the external electrode plates 2 in the width direction.

The resin layer 4 is bonded to each of the side surfaces of the stacked body 10 and is also bonded to the one main surface of the each of the external electrode plates 2. A width W1 of the resin layer 4 disposed on the end of the space between each of the side surfaces of the stacked body 10 and the one main surface of each of the external electrode plates 2 in the width direction is set to a length of, for example, 2 to 40% of a width W2 of the external electrode plates 2. According to the present invention, resin layer 4 protrudes from between the side surface of the stacked body 10 and the one main surface of the external electrode plate 2, and the width W1 does not include the length of the portion protruding from between the side surface of the stacked body 10 and the one main surface of the external electrode plate 2.

With the configuration described above, stress applied on at least one end of the space between the side surfaces of the stacked body 10 and the one main surface of each of the external electrode plates 2 in the width direction is applied to the resin layer 4. As a result, the stress applied to the electrically conductive bonding material 3 is reduced and the formation of cracks in the electrically conductive bonding material 3 is suppressed. Therefore, a multi-layer piezoelectric element 1 with improved durability can be obtained.

In cases where the electrically conductive bonding material 3 is an electrically conductive adhesive containing a resin, preferably the resin layer 4 is provided as a constituent separate from the electrically conductive bonding material 3 (the electrically conductive adhesive) and a boundary between these two constituents exists. With such a configuration, even if cracking occurs in the resin layer 4, progression of the cracking to the electrically conductive bonding material 3 can be suppressed. Additionally, in cases where the electrically conductive bonding material 3 is an electrically conductive adhesive containing a resin, and this resin is the same as the resin forming the resin layer 4, the boundary therebetween will be unclear. In such a case, the boundary is defined by a line formed by connecting electrically conductive particles, from among the electrically conductive particles forming the electrically conductive bonding material 3, located at an edge on the resin layer 4 side. Here, the boundary may be formulated by combining a vertical cross-section cut parallel with the external electrode plate 2 and a horizontal cross-section cut perpendicularly to the external electrode plate 2.

Moreover, as illustrated in FIG. 2, in a cross-sectional view perpendicular to the side surfaces of the stacked body 10, the resin layer 4 is preferably also disposed at the other end of the space between each of the side surfaces of the stacked body 10 and the one main surface of each of the external electrode plates 2 in the width direction. In other words, the resin layer 4 is preferably disposed at both ends of the space between each of the side surfaces of the stacked body 10 and the one main surface of each of the external electrode plates 2 in the width direction. As a result of the resin layer 4 being provided at both ends of the space between each of the side surfaces of the stacked body 10 and the one main surface of each of the external electrode plates 2 in the width direction, stress applied to the electrically conductive bonding material 3 is further mitigated and durability is further improved.

Here, the width W1 of each of the resin layers 4, disposed at each of the ends of the space between each of the side surfaces of the stacked body 10 and the one main surface of each of the external electrode plates 2 in the width direction, is set to a length of, for example, 2 to 20% of the width W2 of the external electrode plates 2.

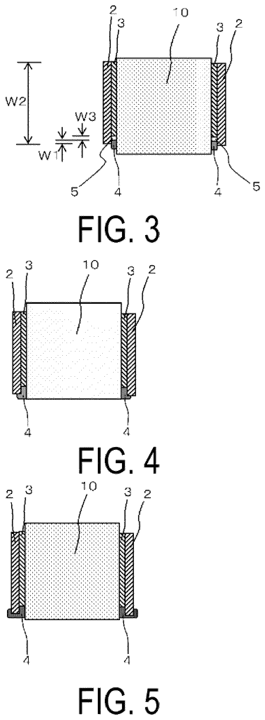

Furthermore, according to the invention and as illustrated in FIG. 3, in a cross-sectional view perpendicular to the side surfaces of the stacked body 10, a gap 5 preferably is located between the electrically conductive bonding material 3 and the resin layer 4 disposed on at least one end of the space between each of the side surfaces of the stacked body 10 and the one main surface of each of the external electrode plates 2 in the width direction. Due to the presence of the gap 5, the progression of cracks that has occurred due to stress being applied to the resin layer 4 will stop at the gap 5 and cracks will not progress to the electrically conductive bonding material 3, leading to further improvements in durability.

Note that a width W3 of the gap 5 disposed between the resin layer 4 and the electrically conductive bonding material 3 is set to a length of, for example, 2 to 20% of the width W2 of the external electrode plates 2. Additionally, in cases where the resin layer 4 is disposed on each end of the space between each of the side surfaces of the stacked body 10 and the one main surface of each of the external electrode plates 2 in the width direction, and the gap 5 is disposed between the electrically conductive bonding material 3 and each of the resin layers 4, the width W3 of each of the gaps 5 is set to a length of, for example, 1 to 10% of the width W2 of the external electrode plates 2.

Additionally, as illustrated in FIG. 4, in a cross-sectional view perpendicular to the side surfaces of the stacked body 10, the resin layer 4 preferably extends to a side surface of the external electrode plate 2. Due to the presence of the resin layer 4 extending to the side surface of the external electrode plate 2, the resin layer 4 will cover the edge of the external electrode plate 2 where stress concentrates and, as a result, cracking is suppressed. Furthermore, even if cracks occur from an edge of the interface between the side surface of the external electrode plate 2 and the resin layer 4, distance to the electrically conductive bonding material 3 is increased and, therefore, the progression of the cracks to the electrically conductive bonding material 3 is suppressed, leading to further improvements in durability.

Additionally, as illustrated in FIG. 5, in a cross-sectional view perpendicular to the side surfaces of the stacked body 10, the resin layer 4 is preferably formed up to a portion of the other main surface of the external electrode plate 2. Due to the presence of the resin layer 4 on a portion of the other main surface of the external electrode plate 2, the distance of cracks, which occur from the edge of the interface between the external electrode plate 2 and the resin layer 4, to the electrically conductive bonding material 3 is increased further and, therefore, the progression of the cracks to the electrically conductive bonding material 3 is suppressed, leading to further improvements in durability. Herein, "the other main surface of the external electrode plate 2" means the main surface on the side opposite the stacked body 10.

According to the present invention, resin layer 4 is disposed so as to protrude from between each of the side surfaces of the stacked body 10 and the one main surface of each of the external electrode plates 2, and cover the external electrode plates 2.

Additionally, the resin layer 4 may be disposed so as to protrude from between each of the side surfaces of the stacked body 10 and the one main surface of each of the external electrode plates 2, and cover the side surfaces of the stacked body 10. That is, there are cases where a cover layer is disposed so as to cover the side surfaces of the stacked body 10 to suppress creeping discharge and migration and to protect the stacked body and the like and, in cases where this cover layer is made from a resin, the cover layer may penetrate between each of the side surfaces of the stacked body 10 and the one main surface of each of the external electrode plates 2. As such, beneficial effects will be obtained in that adhesiveness of the cover layer will increase and cracking of the electrically conductive bonding material 3 will be suppressed.

Next, a manufacturing method of the multi-layer piezoelectric element 1 will be described.

First, ceramic green sheets that will become the piezoelectric layers 11 are fabricated. Specifically, a ceramic slurry is formed by mixing a calcined powder of piezoelectric ceramics, a binder made from an acrylic-based, butyral-based, or similar organic polymer, and a plasticizer. Then, the ceramic green sheets are fabricated using this ceramic slurry by utilizing a doctor blade method, a calender roll method, or similar tape molding method. Any piezoelectric ceramics may be used, provided that the piezoelectric ceramics have piezoelectric properties, and examples thereof include, perovskite-type oxides made from lead zirconate titanate (PbZrO₃-PbTiO₃) and the like. Additionally, dibutyl phthalate (DBP), dioctyl phthalate (DOP), or the like may be used as the plasticizer.

Next, an electrically conductive paste that becomes the internal electrode layers 12 is fabricated. Specifically, an electrically conductive paste is fabricated by adding/blending a binder and a plasticizer to a silver-palladium metal alloy powder. This electrically conductive paste is applied in the pattern of the internal electrode layers 12 on the ceramic green sheets using a screen printing method. Furthermore, a plurality of the ceramic green sheets on which the electrically conductive paste is printed are laminated and subjected to binder removal treatment at a predetermined temperature. Thereafter, firing at a temperature of 900 to 1,200°C is performed and the resulting products are subjected to grinding processing into a predetermined shape using a surface grinding machine or the like. Thus, the active section 13 in which the piezoelectric layers 11 and the internal electrode layers 12 are alternately laminated is fabricated. The inactive sections 14 are fabricated by laminating sheets on which the electrically conductive paste that becomes the internal electrode layers 12 is not applied. The stacked body 10 is manufactured by assembling the active section 13 and the inactive sections 14.

Note that the stacked body 10 is not limited to products fabricated according to the manufacturing method described above and, provided that the stacked body 10 formed by laminating a plurality of the piezoelectric layers 11 and the internal electrode layers 12 together can be fabricated, any manufacturing method may be used to fabricate the stacked body 10.

Next, the external electrode plates 2 are connected and fixed to the side surfaces of the stacked body 10 with the electrically conductive bonding material 3 interposed therebetween.

An adhesive made from an epoxy resin or a polyimide resin containing metal powder with excellent electrical conductivity such as Ag powder, Cu powder, or the like, is used as the electrically conductive bonding material 3 and is formed with a thickness of 5 to 70 µm. The electrically conductive bonding material 3 can be formed so as to be restrained to a predetermined thickness and width by using a screen printing method or dispensing system.

Note that when employing screen printing, an example of a method for providing a place for applying the resin layer 4 includes providing a printing plate for screen printing with predetermined holes and printing. Additionally, when employing a dispensing system, an example of a method for providing a place for applying the resin layer 4 includes using a dispenser that has a needle diameter conforming to the desired application width, not applying material at the place where the resin layer 4 will be applied, and only dispensing material at the desired locations.

The external electrode plates 2 are made from a flat metal plate of copper, iron, stainless steel, phosphor bronze, or the like and are formed, for example, having a width of 0.5 to 10 mm and a thickness of 0.1 to 0.3 mm. Here, examples of methods used to form the external electrode plates 2 into a form having slits in the horizontal direction or a reticulated form include punching using a punching die, laser machining and the like; and a bending die may be used to make curved or bent forms.

Next, the resin layer 4 is applied on the end of the space in the width direction of each of the side surfaces of the stacked body 10 and the external electrode plates 2. The resin layer 4 can be formed by using, for example, an epoxy, acrylic, or imide resin and restraining such formation to a predetermined location and amount by using a dispensing system.

Then, a direct electric field of 0.1 to 3 kV/mm is applied to the external electrode plates 2, and the piezoelectric layers 11 constituting the stacked body 10 are polarized. Thus, the multi-layer piezoelectric element 1 is completed. With this multi-layer piezoelectric element 1, by connecting an external power supply via the external electrode plates 2 and applying voltage to the piezoelectric layers 11, each of the piezoelectric layers 11 can be greatly displaced due to the inverse piezoelectric effect. As a result, it is possible to cause the multi-layer piezoelectric element 1 to function as, for example, a fuel injection valve for an automobile that injects/supplies fuel to an engine.

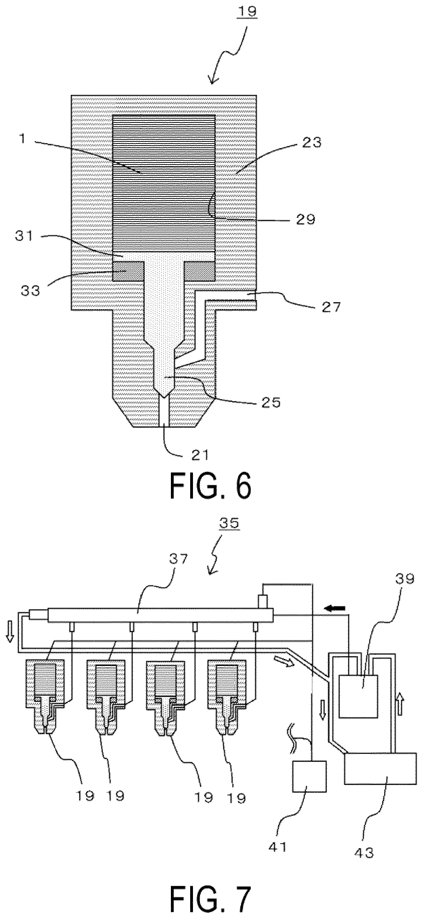

Next, an example of an embodiment of the injection device of the invention is described. FIG. 6 is a schematic cross-section view illustrating an example of an embodiment of the injection device of the invention.

As illustrated in FIG. 6, the injection device 19 of this embodiment is constituted by a housing container (container) 23 including an injection hole 21 at one end thereof, and the multi-layer piezoelectric element 1 of the embodiment described above is contained inside the housing container 23.

A needle valve 25 capable of opening and closing the injection hole 21 is provided in the housing container 23. A fluid passage 27 is provided in the injection hole 21 that is capable of communication with the injection hole 21 depending on movement of the needle valve 25. The fluid passage 27 is connected to an external fluid supply source, which supplies fluid at constant high pressure to the fluid passage 27. Thus, the injection device 19 is configured so that, when the needle valve 25 opens the injection hole 21, the fluid supplied to the fluid passage 27 is discharged out or into an adjacent container, for example, a combustion chamber of an internal combustion engine (not illustrated in the drawings), from the injection hole 21.

The diameter of an upper end portion of the needle valve 25 is larger and constitutes a piston 31 that is slideable in a cylinder 29 formed in the housing container 23. Moreover, the multi-layer piezoelectric element 1 of the example described above is contained in the housing container 23 in contact with the piston 31.

In the injection device 19 described above, when voltage is applied and the multi-layer piezoelectric element 1 elongates, pressure is applied to the piston 31 and the needle valve 25 closes the fluid passage 27 that communicates with the injection hole 21. Thus, the supply of fluid is halted. Additionally, the injection device 19 is configured so that when the application of voltage is halted, the multi-layer piezoelectric element 1 contracts, a plate spring 33 pushes the piston 31 back, the fluid passage 27 is opened, the injection hole 21 communicates with the fluid passage 27, and the fluid is sprayed from the injection hole 21.

Note that the injection device 19 may be configured so that the fluid passage 27 opens when voltage is applied to the multi-layer piezoelectric element 1 and the fluid passage 27 closes when the application of voltage is halted.

Additionally, the injection device 19 of this embodiment may be configured to include a container 23 including an injection hole 21 and the multi-layer piezoelectric element 1 of the embodiment described above, wherein the injection device 19 is configured to discharge the fluid filling the container 23 through the injection hole 21 by driving the multi-layer piezoelectric element 1. That is, it is not necessary for the multi-layer piezoelectric element 1 to be inside the container 23 and any configuration is possible provided that pressure is applied to the inside of the container 23, to control the injection of the fluid, by the driving of the multi-layer piezoelectric element 1. Note that in the injection device 19 of this embodiment, the term "fluid" should be construed to include various types of liquids such as electrically conductive paste and the like and also gases, in addition to fuel, ink, and the like. By using the injection device 19 of this embodiment, the flow rate and spray timing of the fluid can be stably controlled over an extended period of time.

By using the injection device 19 of this embodiment utilizing the multi-layer piezoelectric element 1 of this embodiment in an internal combustion engine, compared to conventional injection devices, the injection device 19 can be made to inject fuel into the combustion chamber of an internal combustion engine such as an engine with high precision over an extended period of time.

Next, an example of an embodiment of the fuel-injection system of the invention is described. FIG. 7 is a schematic diagram illustrating an example of an embodiment of the fuel-injection system of the invention.

As illustrated in FIG. 7, a fuel-injection system 35 of this embodiment includes a common rail 37 configured to store high-pressure fuel as a high-pressure fluid, a plurality of the injection device 19 of the embodiment described above configured to inject the high-pressure fluid stored in the common rail 37, a pressure pump 39 configured to supply the high-pressure fluid to the common rail 37, and an injection control unit 41 configured to send driving signals to the injection device 19.

The injection control unit 41 controls an amount and timing of the injection of the high-pressure fluid on the basis of external information or signals from external sources. For example, in cases where the fuel-injection system 35 of this embodiment is used for fuel injection in an engine, the amount and timing of fuel injection can be controlled while using a sensor or the like to sense the condition within the combustion chamber of the engine. The pressure pump 39 serves a role of supplying fluid fuel from a fuel tank 43 to the common rail 37 at high pressure. For example, in a case of the fuel-injection system 35 of an engine, fluid fuel is pumped to the common rail 37 at high pressures from 1000 to 2000 atmospheres (about 101 MPa to about 203 MPa), and preferably from 1500 to 1700 atmospheres (about 152 MPa to about 172 MPa). The high-pressure fuel supplied from the pressure pump 39 is stored in the common rail 37 and pumped appropriately to the injection device 19. As described previously, the injection device 19 sprays the prescribed fluid out or into an adjacent container from the injection hole 21. For example, in cases where an engine is the target of the injection/supplying of fuel, a high-pressure fuel is sprayed as a mist from the injection hole 21 into the combustion chamber of the engine.

According to the fuel-injection system 35 of this embodiment, desired injection of high-pressure fuel can be stably performed over an extended period of time.

### Examples

Next, examples are described.

The multi-layer piezoelectric element was fabricated as described below. First, a calcined powder of piezoelectric ceramics having lead zirconate titanate (PbZrO₃-PbTiO₃) with an average particle size of 0.4 µm as a primary component, a binder, and a plasticizer were blended. Thus, a ceramic slurry was obtained. Then, using this ceramic slurry, ceramic green sheets of a thickness of 50 µm that would become the piezoelectric layers were fabricated via a doctor blade method.

Then, a binder was added to silver-palladium alloy and an electrically conductive paste that would become the internal electrode layers was fabricated.

Next, the electrically conductive paste that would become the internal electrode layers was printed via a screen printing method on one side of the ceramic green sheets, and 200 of the ceramic green sheets, on which the electrically conductive paste was printed, were laminated together. Additionally, a total of 15 ceramic green sheets, on which the electrically conductive paste that would become the internal electrode layers was not printed, were laminated on top of and under the body of 200 ceramic green sheets, on which the electrically conductive paste that would become the internal electrode layers was printed. Then, firing at 980 to 1100°C was performed and the resulting product was ground into a predetermined shape using a surface grinding machine. Thus, a 5 mm square stacked body was obtained.

Next, an electrically conductive bonding material constituted by a paste-like mixture of Ag powder and polyimide resin was applied to a front surface of the stacked body and the external electrode plates were attached and affixed to the front surface of the stacked body.

Next, using a dispenser, the epoxy resin was applied on an end in the width direction between each of the side surfaces of the stacked body and each of the external electrode plates.

A multi-layer piezoelectric element was fabricated as a Sample 1 using external electrode plates made from phosphor bronze having the cross-section illustrated in FIG. 1A, a thickness of 0.1 mm, and a width of 4.0 mm. An electrically conductive bonding material made from silver polyimide was applied so as to form an electrically conductive bonding material layer between each side surface of the active section and each of the external electrode plates; and had a structure provided with a thickness of 0.03 mm. Specifically, the width of the electrically conductive bonding material to be dispensed from the nozzle diameter of the dispenser was set to be 3.0 mm and the electrically conductive bonding material was applied so that the cross-section illustrated in FIG. 1B was formed. Furthermore, the epoxy resin was applied using the dispenser to one end of the space between each side surface of the stacked body and each of the external electrode plates in the width direction, and the width thereof was 1.0 mm.

Additionally, a multi-layer piezoelectric element was fabricated as a Sample 2 using external electrode plates made from phosphor bronze having the cross-section illustrated in FIG. 2, a thickness of 0.1 mm, and a width of 4.0 mm. Specifically, the electrically conductive bonding material was applied to a center of the external electrode plates at a thickness of 0.03 mm and a width of 3.0 mm so that the resin could be applied, using a dispenser, on both ends of the space between each of the side surfaces of the stacked body and each of the external electrode plates in the width direction. Furthermore, the epoxy resin was applied, using a dispenser, on both ends in the width direction between each of the side surfaces of the stacked body and each of the external electrode plates, and the width at each end thereof was 0.5 mm.

Additionally, a multi-layer piezoelectric element according to the invention was fabricated as a Sample 3 using external electrode plates made from phosphor bronze having the cross-section illustrated in FIG. 3, a thickness of 0.1 mm, and a width of 4.0 mm. Specifically, the electrically conductive bonding material was applied using a dispenser at a thickness of 0.03 mm and a width of 3.0 mm. Furthermore, the epoxy resin was applied, using a dispenser, one end of the space between each of the side surfaces of the stacked body and each of the external electrode plates in the width direction, and the width thereof was 0.5 mm. Here, the position of the dispenser for applying the epoxy resin was adjusted so as to provide a gap between the electrically conductive bonding material and the epoxy resin, and a gap of 0.5 mm was provided.

Additionally, a multi-layer piezoelectric element was fabricated as a Sample 4 using external electrode plates made from phosphor bronze having the cross-section illustrated in FIG. 4, a thickness of 0.1 mm, and a width of 4.0 mm. Specifically, the electrically conductive bonding material was applied using a dispenser at a thickness of 0.03 mm and a width of 3.0 mm. Furthermore, the epoxy resin was applied using the dispenser to one end of the space between each side surface of the stacked body and each of the external electrode plates in the width direction, and the width thereof was 1.0 mm. Here, the amount of the epoxy resin was adjusted so as to cover 0.05 mm of the thickness of the side surface of the external electrode plates.

Additionally, a multi-layer piezoelectric element was fabricated as a Sample 5 using external electrode plates made from phosphor bronze having the cross-section illustrated in FIG. 5, a thickness of 0.1 mm, and a width of 4.0 mm. Specifically, the electrically conductive bonding material was applied using a dispenser at a thickness of 0.03 mm and a width of 3.0 mm. Furthermore, the epoxy resin was applied using the dispenser to one end of the space between each side surface of the stacked body and each of the external electrode plates in the width direction, and the width thereof was 1.0 mm. Here, the amount of the epoxy resin was adjusted so as to cover all of the side surface of the external electrode plates and to cover 1.0 mm of a top surface of the external electrode plates.

Additionally, a multi-layer piezoelectric element (Sample 6) was fabricated as a Comparative Example using external electrode plates having the cross-section illustrated in FIGS. 8A and 8B. Here, external electrode plates having a thickness of 0.1 mm and a width of 4.0 mm were used, and the electrically conductive bonding material was provided so that a thickness thereof was 0.03 mm and a width thereof was 4 mm.

These multi-layer piezoelectric elements were subjected to polarization treatment by applying a direct electric field of 3 kV/mm for 15 minutes to the external electrode plate via a lead member welded and connected to the external electrode plate. Upon the application of 160 V of direct current voltage to the multi-layer piezoelectric elements, displacement in an amount of 30 µm in the stacking direction of the stacked body was obtained.

Furthermore, 0 V to 160 V of alternating current was applied at a frequency of 150 Hz in a 30°C, 90% humidity environment, and a durability test for continuous driving was performed.

As a result, with the multi-layer piezoelectric element of the Comparative Example, namely Sample 6, detachment of the external electrode plates occurred at 1 × 10⁴ continuous drives and the driving thereof halted at 1 × 10⁵ continuous drives.

In contrast, with the multi-layer piezoelectric element of Samples 1, 2, 3, 4, and 5 of the Working Example including sample 3 according to the invention, of the invention, the external electrode plates did not detach even after 1 × 10⁷ continuous drives.

It is clear from the results described above that, according to the present invention, a multi-layer piezoelectric element with improved long-term durability can be realized.

### Reference Signs List

1 Multi-layer piezoelectric element
10 Stacked body
11 Piezoelectric layer
12 Internal electrode layer
13 Active section
14 Inactive section
2 External electrode plate
3 Electrically Conductive bonding material
4 Resin layer
5 Gap

## Claims

1. A multi-layer piezoelectric element (1) comprising:
a stacked body (10) comprising piezoelectric layers (11) and internal electrode layers (12) laminated together;
an external electrode plate (2) connected to a side surface of the stacked body (10) and electrically connected to the internal electrode layers (12); and
an electrically conductive bonding material (3) disposed between the side surface of the stacked body (10) and one main surface of the external electrode plate (2); wherein
a resin layer (4) free of electrical conductive particles is disposed on at least one end of a space between the side surface of the stacked body (10) and the one main surface of the external electrode plate (2) in a width direction in a cross-sectional view perpendicular to the side surface of the stacked body (10), **characterised in that**
the resin layer (4) is disposed to protrude from between the side surface of the stacked body (10) and the one main surface of the external electrode plate (2), and
a gap (5) is located between the electrically conductive bonding material (3) and the resin layer (4).

2. The multi-layer piezoelectric element (1) according to claim 1, wherein the resin layer (4) is disposed on both ends of the space between the side surface of the stacked body (10) and the one main surface of the external electrode plate (2) in the width direction.

3. The multi-layer piezoelectric element (1) according to claim 1 or 2, wherein the resin layer (4) extends to the side surface of the external electrode plate (2).

4. The multi-layer piezoelectric element (1) according to claim 1 or 2, wherein the resin layer (4) comprises a portion coming around onto the other main surface of the external electrode plate (2).

5. The multi-layer piezoelectric element (1) according to any one of claims 1 to 4, wherein the resin layer (4) is disposed to cover the side surface of the stacked body (10).

6. An injection device (19) comprising:
a container (23) comprising an injection hole (21); and
the multi-layer piezoelectric element (1) according to any one of claims 1 to 5, wherein
the injection device (19) is configured to discharge a fluid stored within the container (23) through the injection hole (21) by driving the multi-layer piezoelectric element (1).

7. A fuel-injection system (35) comprising:
a common rail (37) for storing high-pressure fuel;
the injection device (19) according to claim 6 for injecting the high-pressure fuel stored in the common rail (37);
a pressure pump (39) for supplying the high-pressure fuel to the common rail (37); and
an injection control unit (41) for sending driving signals to the injection device (19).

## Patentansprüche

1. Mehrschicht- piezoelektrisches Element (1), aufweisend:
einen Stapelkörper (10), der piezoelektrische Schichten (11) und innere Elektrodenschichten (12) aufweist, die zusammenlaminiert sind,
eine externe Elektrodenplatte (2), die mit einer Seitenfläche des Stapelkörpers (10) verbunden ist und elektrisch mit den inneren Elektrodenschichten (12) verbunden ist, und
ein elektrisch leitfähiges Verbindungsmaterial (3), das zwischen der Seitenfläche des Stapelkörpers (10) und einer Hauptfläche der externen Elektrodenplatte (2) angeordnet ist, wobei
eine Harzschicht (4), die frei von elektrisch leitfähigen Partikeln ist, an mindestens einem Ende eines Raumes zwischen der Seitenfläche des Stapelkörpers (10) und der einen Hauptfläche der externen Elektrodenplatte (2) in einer Breitenrichtung in einer Querschnittsansicht senkrecht zu der Seitenfläche des Stapelkörpers (10) angeordnet ist, **dadurch gekennzeichnet, dass**
die Harzschicht (4) angeordnet ist, um von zwischen der Seitenfläche des Stapelkörpers (10) und der einen Hauptfläche der externen Elektrodenplatte (2) hervorzustehen, und
ein Spalt (5) zwischen dem elektrisch leitfähigen Verbindungsmaterial (3) und der Harzschicht (4) angeordnet ist.

2. Mehrschicht- piezoelektrisches Element (1) gemäß Anspruch 1, wobei die Harzschicht (4) an beiden Enden des Raumes zwischen der Seitenfläche des Stapelkörpers (10) und der einen Hauptfläche der externen Elektrodenplatte (2) in der Breitenrichtung angeordnet ist.

3. Mehrschicht- piezoelektrisches Element (1) gemäß Anspruch 1 oder 2, wobei sich die Harzschicht (4) zu der Seitenfläche der externen Elektrodenplatte (2) erstreckt.

4. Mehrschicht- piezoelektrisches Element (1) gemäß Anspruch 1 oder 2, wobei die Harzschicht (4) einen Abschnitt aufweist, der sich auf die andere Hauptfläche der externen Elektrodenplatte (2) erstreckt.

5. Mehrschicht- piezoelektrisches Element (1) gemäß irgendeinem der Ansprüche 1 bis 4, wobei die Harzschicht (4) angeordnet ist, um die Seitenfläche des Stapelkörpers (10) zu bedecken.

6. Einspritzvorrichtung (19), aufweisend:
einen Behälter (23), der ein Einspritzloch (21) aufweist, und
das Mehrschicht- piezoelektrische Element (1) gemäß irgendeinem der Ansprüche 1 bis 5, wobei
die Einspritzvorrichtung (19) konfiguriert ist, um ein in dem Behälter (23) gespeichertes Fluid durch Ansteuern/Antreiben des Mehrschicht- piezoelektrischen Elements (1) durch das Einspritzloch (21) hindurch auszustoßen.

7. Kraftstoffeinspritzsystem (35), aufweisend:
einen Common Rail (37) zum Speichern von Hochdruckkraftstoff,
die Einspritzvorrichtung (19) gemäß Anspruch 6 zum Einspritzen des in dem Common Rail (37) gespeicherten Hochdruckkraftstoffs,
eine Druckpumpe (39) zum Zuführen des Hochdruckkraftstoffs an den Common Rail (37), und
eine Einspritzsteuereinheit (41) zum Senden von Ansteuer-/Antriebssignalen an die Einspritzvorrichtung (19).

## Revendications

1. Un élément piézoélectrique multicouche (1), comprenant :
un corps empilé (10) comprenant des couches piézo-électriques (11) et des couches d'électrodes internes (12) laminées ensemble ;
une plaque d'électrode externe (2) connectée à une surface latérale du corps empilé (10) et connectée électriquement aux couches d'électrodes internes (12) ; et
un matériau de liaison électriquement conducteur (3) disposé entre la surface latérale du corps empilé (10) et une surface principale de la plaque d'électrode externe (2) ; dans lequel
une couche de résine (4) exempte de particules électriquement conductrices est disposée sur au moins une extrémité d'un espace entre la surface latérale du corps empilé (10) et ladite une surface principale de la plaque d'électrode externe (2) dans un sens de largeur, dans une vue en coupe transversale perpendiculaire à la surface latérale du corps empilé (10), **caractérisé en ce que**
la couche de résine (4) est disposée de manière à faire saillie entre la surface latérale du corps empilé (10) et ladite une surface principale de la plaque d'électrode externe (2), et
un espace (5) est situé entre le matériau de liaison électriquement conducteur (3) et la couche de résine (4).

2. L'élément piézoélectrique multicouche (1) selon la revendication 1, dans lequel la couche de résine (4) est disposée aux deux extrémités de l'espace entre la surface latérale du corps empilé (10) et ladite une surface principale de la plaque d'électrode externe (2) dans le sens de largeur.

3. L'élément piézoélectrique multicouche (1) selon la revendication 1 ou 2, dans lequel la couche de résine (4) s'étend jusqu'à la surface latérale de la plaque d'électrode externe (2).

4. L'élément piézoélectrique multicouche (1) selon la revendication 1 ou 2, dans lequel la couche de résine (4) comprend une partie qui s'étend sur l'autre surface principale de la plaque d'électrode externe (2).

5. L'élément piézoélectrique multicouche (1) selon l'une quelconque des revendications 1 à 4, dans lequel la couche de résine (4) est disposée de manière à couvrir la surface latérale du corps empilé (10).

6. Un dispositif d'injection (19), comprenant :
un récipient (23) comprenant un trou d'injection (21) ; et
l'élément piézoélectrique multicouche (1) selon l'une quelconque des revendications 1 à 5, dans lequel
le dispositif d'injection (19) est configuré pour décharger un fluide stocké dans le récipient (23) par de trou d'injection (21) en actionnant l'élément piézoélectrique multicouche (1).

7. Un système d'injection de carburant (35), comprenant :
une rampe commune (37) pour le stockage de carburant à haute pression ;
le dispositif d'injection (19) selon la revendication 6 pour injecter le carburant à haute pression stocké dans la rampe commune (37) ;
une pompe à pression (39) pour fournir le carburant à haute pression à la rampe commune (37) ; et
une unité de commande d'injection (41) pour émettre des signaux de commande au dispositif d'injection (19).
